(19) Europäisches Patentamt
European Patent Office
Office européen des brevets

(11) Veröffentlichungsnummer : **0 167 778**
**B1**

(12) # EUROPÄISCHE PATENTSCHRIFT

(45) Veröffentlichungstag der Patentschrift : **21.10.87**

(51) Int. Cl.⁴ : **C 07 C143/68**, G 03 F 7/08

(21) Anmeldenummer : **85106567.2**

(22) Anmeldetag : **29.05.85**

(54) **Perfluoralkylgruppen aufweisende 1,2-Naphthochinondiazidverbindungen und Reproduktionsmaterialien, die diese Verbindungen enthalten.**

(30) Priorität : **08.06.84 DE 3421471**

(43) Veröffentlichungstag der Anmeldung : **15.01.86 Patentblatt 86/03**

(45) Bekanntmachung des Hinweises auf die Patenterteilung : **21.10.87 Patentblatt 87/43**

(84) Benannte Vertragsstaaten : **CH DE FR GB LI**

(56) Entgegenhaltungen :
**DE-A- 3 215 112**
**US-A- 4 024 122**

(73) Patentinhaber : **HOECHST AKTIENGESELLSCHAFT**
**Postfach 80 03 20**
**D-6230 Frankfurt am Main 80 (DE)**

(72) Erfinder : **Müller, Werner H., Dr. Dipl.-Chem.**
**22 Coveside Ct.**
**East Greenwich, R.I. 02818 (US)**

**EP 0 167 778 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft lichtempfindliche, Perfluoralkylgruppen aufweisende 1,2-Naphthochinondiazidverbindungen und lichtempfindliche Reproduktionsmaterialien, die diese Verbindungen enthalten und zur Herstellung von Druckformen für den wasserlosen Offsetdruck geeignet sind.

Beim wasserlosen Flachdruck, insbesondere Offsetdruck wird — im Unterschied zum üblicherweise eingesetzten Offsetdruck — beim Drucken die Differenzierung in Bild- und Nichtbildstellen nicht durch das gleichzeitige Einwirken von Wasser oder wasserhaltigen Flüssigkeiten einerseits und Druckfarbe andererseits bewirkt, sondern die Differenzierung erfolgt in der Regel durch eine unterschiedliche Wechselwirkung zwischen farbannehmenden und (nichtwasserfeuchten) farbabweisenden Stellen auf einer Druckplattenoberfläche mit der Druckfarbe. Aus dem Stand der Technik sind dazu beispielsweise die folgenden Druckschriften bekannt :

In der DE-C 15 71 890 (= US-A 3 677 178) wird eine Druckplatte beschrieben, die auf einem Trägermaterial aus einem Metall, einem Kunststoff oder Papier eine Schicht aus einem hydrophoben und oleophoben Silikonkautschuk und eine strahlungsempfindliche Reproduktionsschicht in dieser oder der umgekehrten Reihenfolge aufweist. Die Reproduktionsschicht enthält als strahlungsempfindliche Verbindung Ammoniumdichromat, Formaldehydkondensate von Diphenylamin-4-diazoniumsalzen oder Polyvinylcinnamat. Die beim Drucken farbführenden Stellen sind entweder freigelegte Teile des Trägermaterials oder durch das Bestrahlen gehärtete Teile der Reproduktionsschicht.

Die Druckplatte gemäß der DE-B 16 71 637 (= US-A 3 511 178 und 3 682 633) weist auf einem Trägermaterial zunächst eine strahlungsempfindliche Reproduktionsschicht und darauf eine Beschichtung auf, die gegenüber Druckfarben einen geringeren Ablösewert (geringere adhäsive Wechselwirkung) als das Trägermaterial hat. Die letzgenannte Beschichtung besteht entweder aus einem Polysiloxan (Silikonelastomer) oder einer fluorhaltigen organischen Verbindung wie einem Homopolymer aus dem Methylacrylsäureester des Perfluoroctanols.

Weitere Ausgestaltungen von Druckplatten für den wasserlosen Offsetdruck bzw. von dafür geeigneten Verbindungen sind beispielsweise den folgenden Druckschriften zu entnehmen :

In der DE-A 25 24 562 (= GB-A 1 501 128) werden strahlungsempfindliche Beschichtungen beschrieben, die ein aromatisches Diazoniumkation, ein Anion einer Perfluoralkylgruppen aufweisenden Carbon- oder Sulfonsäure und gegebenenfalls ein polymeres organisches Bindemittel enthalten. Von dieser Schicht soll nach dem Bestrahlen direkt, d. h. ohne Entwicklungsschritt, gedruckt werden können.

Der EP-A 0 037 094 ist zu entnehmen, daß strahlungsempfindliche Polymere (u. a. für den Einsatz als Beschichtung für Druckplatten) hergestellt werden können, die Copolymerisate aus a) Acrylsäure- oder Methacrylsäure-perfluoralkylestern und b) Acrylsäure- oder Methacrylsäure-azidobenzoyloxy-alkylestern sind. Strahlungsempfindliche Reproduktionsschichten können neben diesen Copolymerisaten auch noch wäßrig-alkalisch entwickelbare organische Bindemittel und übliche Hilfsmittel enthalten. Nach der Bestrahlung und Entwicklung wird auf dem Trägermaterial ein Reliefbild erzeugt.

Die farbabweisenden Bereiche praktisch aller dieser bekannten Flachdruckplatten enthalten entweder Polysiloxane oder hochfluorierte organische Verbindungen. Obwohl die Polysiloxane ein hervorragendes Farbabstoßungsvermögen aufweisen, haben Platten mit derartigen Substanzen den Nachteil, daß die zu ihrer Verarbeitung verwendeten Geräte und Materialien durch die Polysiloxane dauerhaft verunreinigt werden, so daß sie kaum noch zu anderen Zwecken genutzt werden können.

Ein weiterer Nachteil der bisher verfügbaren wasserlos druckenden Offsetplatten ist es, daß sie, von wenigen Ausnahmen abgesehen, mit lichthärtbaren Schichten bzw. Verbindungen arbeiten und damit positiv arbeiten. Die Umkehr ergibt sich daraus, daß in der Regel die belichteten Bereiche mit der darüberliegenden farbabweisenden Schicht bei der Entwicklung stehenbleiben und von dem freigelegten Schichtträger oder einer farbannehmenden Unterschicht gedruckt wird.

Eine der wenigen bekannten negativ arbeitenden Platten für den wasserlosen Offsetdruck ist in der DE-A 29 43 379 beschrieben. Dort befindet sich auf einem Schichtträger eine lichtempfindliche Schicht, die einen 1,2-Chinondiazidsulfonsäureester eines Phenolharzes enthält, wobei nicht mehr als 20 % der Schicht in Ethanol löslich sind. Über der lichtempfindlichen Schicht liegt eine Silikongummischicht. Die Platte erfordert eine Entwicklung mit Ethanol, da die farbabweisende Deckschicht von wäßrigen Entwicklerlösungen nicht benetzt wird.

Aufgabe der Erfindung war es, eine vorsensibilisierte Druckplatte, die sich mit wäßrigen Lösungen zu einer ohne Befeuchtung ein negatives Bild der Vorlage druckenden Flachdruckform verarbeiten läßt, sowie neue lichtempfindliche Verbindungen vorzuschlagen, die zum Einsatz in der vorsensibilisierten Druckplatte geeignet sind.

Erfindungsgemäß werden neue Perfluoralkylgruppen aufweisende 1,2-Naphthochinon-2-diazidsulfonsäureester der allgemeinen Formel I

$$(R_FW)_p-\overset{\overset{\displaystyle R^1}{|}}{Ar}(-OD)_n \qquad \text{(I)}$$

vorgeschlagen, worin

Ar einen ein- bis dreikernigen aromatischen Rest,

D einen 1,2-Naphthochinon-2-diazid-4- oder einen 1,2-Naphthochinon-2-diazid-5-sulfonylrest,

$R_F$ einen Perfluoralkylrest mit 5 bis 15 Kohlenstoffatomen,

W eine Einfachbindung oder eine der Gruppen

$—(CH_2)_mCOO—$
$—(CH_2)_mO—C_oH_{2o}—COO—$
$—(CH_2)_mOOC—C_oH_{2o}—COO—$
$—(CH_2)_mOOC—CH{=}CH—COO—$
$—(CH_2)_mCO—$
$—(CH_2)_mSO_3—$
$—C_6H_4SO_3—$
$—(CH_2)_mOOC—CHR^2—O—$
$—(CH_2)_mOOC—$
$—(CH_2)_mSO_2NH—$
$—C_6H_4SO_2NH—$
$—(CH_2)_mCONH—$
$—(CH_2)_mOOC—C_oH_{2o}—CONH—$
$—(CH_2)_mOOC—CH{=}CH—CONH—$,

$R^1$ ein Wasserstoff- oder Halogenatom, eine Alkyl- oder Alkoxygruppe mit 1 bis 5 Kohlenstoffatomen, eine Acetyl- oder Propionylgruppe,

$R^2$ eine Alkylgruppe mit 1 bis 12 Kohlenstoffatomen,

m 0 oder eine Zahl von 1 bis 6,

n eine Zahl von 1 bis 3,

o eine Zahl von 1 bis 12 und

p eine Zahl von 1 bis 3

bedeutet.

Erfindungsgemäß wird ferner ein lichtempfindliches Reproduktionsmaterial für die Herstellung von wasserlos druckenden Flachdruckformen, bestehend aus einem Schichtträger und einer lichtempfindlichen Schicht, die ein 1,2-Naphthochinondiazid enthält, vorgeschlagen, das dadurch gekennzeichnet ist, daß das 1,2-Naphthochinondiazid eine Verbindung der allgemeinen Formel I

$$(R_FW)_p—\overset{\displaystyle R^1 \atop |}{Ar}(—OD)_n \qquad (I)$$

ist, worin

Ar einen ein- bis dreikernigen aromatischen Rest,

D einen 1,2-Naphthochinon-2-diazid-4- oder einen 1,2-Naphthochinon-2-diazid-5-sulfonylrest,

$R_F$ einen Perfluoralkylrest mit 5 bis 15 Kohlenstoffatomen,

W eine Einfachbindung oder eine der Gruppen

$—(CH_2)_mCOO—$
$—(CH_2)_mO—C_oH_{2o}—COO—$
$—(CH_2)_mOOC—C_oH_{2o}—COO—$
$—(CH_2)_mOOC—CH{=}CH—COO—$
$—(CH_2)_mCO—$
$—(CH_2)_mSO_3—$
$—C_6H_4SO_3—$
$—(CH_2)_mOOC—CHR^2—O—$
$—(CH_2)_mOOC—$
$—(CH_2)_mSO_2NH—$
$—C_6H_4SO_2NH—$
$—(CH_2)_mCONH—$
$—(CH_2)_mOOC—C_oH_{2o}—CONH—$
$—(CH_2)_mOOC—CH{=}CH—CONH—$,

$R^1$ ein Wasserstoff- oder Halogenatom, eine Alkyl- oder Alkoxygruppe mit 1 bis 5 Kohlenstoffatomen, eine Acetyl- oder Propionylgruppe,

$R^2$ eine Alkylgruppe mit 1 bis 12 Kohlenstoffatomen,

m 0 oder eine Zahl von 1 bis 6,

n eine Zahl von 1 bis 3,

o eine Zahl von 1 bis 12 und

p eine Zahl von 1 bis 3

bedeutet.

In den erfindungsgemäßen Verbindungen sind die Perfluoralkylgruppen $R_F$ gesättigt oder ungesättigt, verzweigt oder unverzweigt ; sie sind bevorzugt unverzweigt und weisen maximal zwei Doppelbindungen im Molekülrest auf.

Die Gruppe Ar kann ein vom Benzol, Naphthalin, Anthracen oder Phenanthren abgeleiteter Rest sein. Sie kann auch mit Vorteil aus zwei durch eine Einfachbindung oder eine der Gruppen —O—, —S—, $—C_rH_{2r}—$ mit r = 1-10, —CO— oder $—SO_2—$ verbundenen Benzolringen bestehen. Im allgemeinen werden Verbindungen bevorzugt, in denen Ar keine anellierten Benzolringe enthält. Besonders bevorzugt werden Verbindungen, in denen Ar ein Benzophenonrest ist.

Unter den fluorierten Resten werden solche bevorzugt, in denen W eine der Gruppen $—(CH_2)_mCOO—$, $—(CH_2)_mOOC—CH{=}CH—COO—$, $—C_6H_4SO_3—$, $—(CH_2)_mCO—$ und $—(CH_2)_mOOC—$ ist.

Es werden ferner solche Verbindungen bevorzugt, in denen p = 1 oder 2, insbesondere gleich 1, n = 2 oder 3, m = 0, 1 oder 2 und 0 eine Zahl von 1 bis 4 ist ; $R^2$ hat bevorzugt nicht mehr als 3 Kohlenstoffatome.

Die erfindungsgemäßen Verbindungen können analog zu bekannten Verbindungen wie folgt hergestellt werden :

1. Durch stufenweise oder gleichzeitige Einführung von mindestens einer Perfluoralkylgruppe und mindestens einer Naphthochinondiazidsulfonylgruppe in eine aromatische Polyhydroxyverbindung. Dabei wird die Polyhydroxyverbindung $R^1$—$Ar(OH)_{n+p}$ mit einer Verbindung $R_FWX$ und einem 1,2-Naphthochinon-2-diazid-4- oder -5-sulfonylhalogenid umgesetzt. X bedeutet ein Halogenatom, wobei als Halogen allgemein Chlor bevorzugt wird.

2. Durch Umsetzen von Phenolen $R^1$—$Ar(OH)_n$ mit Fluoralkylhalogeniden oder Fluoralkansäurehalogeniden $R_FWX$ unter Friedel-Crafts-Bedingungen. Dabei kann W die Bedeutung $-(CH_2)_mCOO-$, $-(CH_2)_mO-C_0H_{20}-COO-$, $-(CH_2)_mOOC-CH=CH-COO-$ oder $-(CH_2)_mCO-$ haben oder eine Einfachbindung sein.

Diese Verbindungen können auch aus entsprechenden Verbindungen $R^1$—$Ar(OWR_F)$ $(OH)_{n-1}$ durch Fries'sche Verschiebung erhalten werden. Anschließend werden die OH-Gruppen mit Naphthochinondiazidsulfonsäurechlorid umgesetzt.

3. Durch Veresterung von aromatischen Hydroxycarbonsäuren mit Perfluoralkylalkoholen und Umsetzung der Hydroxygruppen mit Naphthochinondiazidsulfonsäurechlorid. Als aromatische Hydroxycarbonsäuren sind auch Hydroxynaphthoesäuren geeignet.

4. Durch Umsetzen von Aminophenolen $R^1$—$Ar(NH_2)$ $(OH)_n$ mit einem Acylhalogenid $R_FWX$ zur Acylaminoverbindung und anschließende Veresterung der OH-Gruppen mit Naphthochinondiazidsulfonsäurehalogenid.

Die erfindungsgemäßen fluorierten Naphthochinondiazide werden in lichtempfindlichen Reproduktionsmaterialien eingesetzt, die in üblicher Weise aus einem Schichtträger und einer lichtempfindlichen Schicht bestehen.

Die lichtempfindliche Schicht kann allein aus den neuen Naphthochinondiaziden bestehen. Sie enthält aber bevorzugt weitere übliche Bestandteile, insbesondere ein polymeres Bindemittel. Als Bindemittel werden vor allem wasserunlösliche, in wäßrig-alkalischen Lösungen lösliche Polymere bevorzugt.

Geeignete Bindemittel sind natürliche Harze wie Schellack und Kolophonium und synthetische Polymere, wie Mischpolymerisate aus Styrol und Maleinsäureanhydrid oder Mischpolymerisate der Acryl- oder Methacrylsäure, insbesondere mit Acryl- oder Methacrylsäureestern. Bevorzugt werden die für Positivplatten bewährten Novolake, besonders die höherkondensierten Harze aus substituierten Phenolen, z. B. Kresolen, und Formaldehyd. Auch Polyvinylphenole können mit Vorteil eingesetzt werden.

Als besonders vorteilhaft zur Kombination mit den erfindungsgemäßen Verbindungen haben sich solche Bindemittel erwiesen, die Einheiten mit seitenständigen Perfluoralkylgruppen enthalten.

Als derartige Bindemittel werden insbesondere diejenigen bevorzugt, die in den gleichzeitig eingereichten Patentanmeldungen P 34 21 526.3 (interne Bezeichnung : Hoe 84/K049) und P 34 21 448.8 (interne Bezeichnung : Hoe 84/K050) jeweils mit dem Titel « Perfluoralkylgruppen aufweisende Copolymere (Polymere), sie enthaltende Reproduktionsschichten und deren Verwendung für den wasserlosen Offsetdruck » erstmalig beschrieben sind. Dies sind u. a. Copolymerisate aus Perfluoralkylacrylaten und Acrylaten mit mindestens einer phenolischen OH-Gruppe oder Cokondensate aus einer phenolischen Komponente mit Perfluoralkylgruppen und einer kondensationsfähigen Verbindung.

Die lichtempfindlichen Schichten der erfindungsgemäßen Reproduktionsmaterialien enthalten im allgemeinen 5 bis 65, vorzugsweise 10 bis 50 Gew.-% an erfindungsgemäßen Naphthochinondiaziden. Die polymeren Bindemittel sind im allgemeinen in einer Menge von 35 bis 90, vorzugsweise 50 bis 85 Gew.-%, jeweils bezogen auf den Gehalt an nichtflüchtigen Bestandteilen, in der Schicht enthalten.

Außer alkalilöslichen Harzen können noch zahlreiche andere Harze mitverwendet werden, bevorzugt Epoxide und Vinylpolymerisate wie Polyvinylacetate, Polyacrylate, Polyvinylacetale, Polyvinylether, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gew.-% vom alkalilöslichen Harz. In geringen Mengen kann die lichtempfindliche Schicht für spezielle Erfordernisse wie Flexibilität, Haftung, Glanz, Färbung und Farbumschlag etc. außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether oder 1-Methoxy-propan-2-ol und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den

Schichtkomponenten nicht irreversibel reagieren. Partialether von Glykolen werden besonders bevorzugt.

Als Schichtträger werden meist Metalle verwendet. Für offsetdruckplatten können eingesetzt werden : walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann. Weitere geeignete Metalle sind Stahl und Chrom. Da es, im Gegensatz zu üblichen Flachdruckplatten, nicht erforderlich ist, daß die Trägeroberfläche hydrophil ist, können mit Vorteil auch Kupfer, Messing oder andere oleophile Metalle als Trägeroberfläche dienen. Ebenso können Kunststoffolien, wie Polyester-, Polycarbonat-, Polyimid- oder auch Celluloseacetatfolien verwendet werden, deren Oberfläche ggf. zur Erhöhung der Benetzbarkeit durch Druckfarbe vorbehandelt sein kann. Es ist auch möglich, zur Anpassung an das Benetzungsverhalten der gewünschten Druckfarbe eine Zwischenschicht auf den Schichtträger aufzubringen, die sich im Entwickler nicht löst.

Das Trägermaterial dient bei den Druckformen, die aus dem erfindungsgemäßen Reproduktionsmaterial hergestellt werden, im Gegensatz zu sonst üblichen Druckformen, als farbführendes Material. Die nach dem Belichten und Entwickeln stehengebliebene lichtempfindliche Schicht dient als Bildhintergrund und wirkt in trockenem Zustand farbabstoßend. Zum Druck können dabei sowohl übliche Druckfarben auf Ölbasis als auch spezielle hydrophile Druckfarben dienen, wie sie für den wasserlosen Offsetdruck sowie für den umgekehrten Offsetdruck entwickelt wurden und im Handel erhältlich sind. Da die meisten gebräuchlichen Schichtträgeroberflächen, z. B. aufgerauhtes oder anodisch oxydiertes Aluminium, stark hydrophil sind, werden hydrophile Druckfarben mit Vorteil eingesetzt.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag. Belichtet wird mit den in der Technik üblichen Lichtquellen. Auch das Bestrahlen mit Elektronen oder Lasern stellt eine Möglichkeit zur Bebilderung dar.

Die zum Entwickeln verwendeten wäßrig-alkalischen Lösungen abgestufter Alkalität, vorzugsweise mit einem pH im Bereich von 10-14, die auch kleinere Mengen organischer Lösungs- oder Netzmittel enthalten können, entfernen die vom Licht getroffenen Stellen der Kopierschicht und erzeugen so auf der Platte ein positives Abbild der Vorlage. Wegen der Umkehrwirkung einer wasserlos druckenden Offsetplatte wird im Druck ein Negativ der Vorlage erhalten.

Die folgenden Ausführungsbeispiele erläutern bevorzugte Ausführungsformen der Erfindung. Es folgt zunächst eine allgemeine Herstellungsvorschift für die erfindungsgemäßen Verbindungen. Danach folgen 8 Synthesebeispiele und 13 Anwendungsbeispiele. In den Beispielen sind Mengenverhältnisse und Prozentzahlen in Gewichtseinheiten zu verstehen, wenn nichts anderes angegeben ist.

Allgemeine Vorschrift für die Umsetzung von Polyhydroxyphenolen mit Chloriden fluorierter organischer Säuren und 1,2-Naphthochinon-2-diazidsulfonsäurechloriden :

0,1 (n — 1) mol 1,2-Naphthochinon-2-diazidsulfonsäurechlorid, 0,1 mol eines n-wertigen Phenols und 0,1 mol fluoriertes Säurechlorid werden in 350 ml Dioxan gelost. Dazu tropft man unter Rühren und Eiskühlung (Temperatur maximal 25 °C) innerhalb einer Stunde 0,11 n mol Triethylamin, gelöst in 80 ml Dioxan. Anschließend wird noch 4 Stunden bei Raumtemperatur nachgerührt, vom ausgefallenen Triethylaminhydrochlorid abfiltriert und die Lösung in ca. 4 Liter Eiswasser, das mit Salzsäure auf etwa pH 3 gehalten wird, eingerührt. Der Niederschlag wird abfiltriert, mit Wasser gewaschen und im Umlufttrockenschrank über Nacht bei 30 °C getrocknet. Die Struktur der Verbindungen wird jeweils durch Kernresonanz-(NMR)-Spektren für $^{1}H$ und $^{19}F$ bestätigt.

Synthesebeispiele 1 bis 6

Umsetzungen von 1 mol 2,3,4-Trihydroxy-benzophenon mit 2 mol 1,2-Naphthochinon-2-diazidsulfonsäurechlorid und 1 mol fluoriertem Säurechlorid.

(Siehe Tabelle I Seite 6 f.)

Synthesebeispiel 7

A) Herstellung von 1,3-Dihydroxy-4-perfluoroctanoylbenzol

11 g (0,1 mol) Resorcin werden in 150 ml 1,2-Dichlorethan 10 Minuten am Rückfluß erhitzt. Die Lösung wird dann unter Rühren im Eisbad auf 0 °C abgekühlt und in einer Portion mit 32 g wasserfreiem Aluminiumchlorid versetzt. Im Verlauf von 2 Stunden werden bei 0-5 °C 43,2 g (0,1 mol) Perfluoroctansäurechlorid zugetropft. Dann wird das Eisbad entfernt und das Reaktionsgemisch noch 4 Stunden bei Raumtemperatur gerührt. Das Gemisch wird dann auf Eis gegossen und mit Methylenchlorid mehrmals extrahiert ; die vereinigten Extrakte werden mit Wasser gewaschen, über Magnesiumsulfat getrocknet und am Rotationsverdampfer zur Trockne eingeengt.

Ausbeute : 45,9 g = 91 % d. Th.

Summenformel : $C_{14}F_{15}H_5O_3$ % F : ber : 56,3 ; gef. : 56,3

Tabelle I

| Synthese-beispiel Nr. | D-Cl | $R_FWCl$ | Produkte: Summenformel | Produkte: Ausbeute % | % F ber. | % F gef. | % N ber. | % N gef. |
|---|---|---|---|---|---|---|---|---|
| 1 | $D_5$-Cl | $CF_3(CF_2)_{5,5}CH_2COCl$ | $C_{41,5}F_{14}H_{19}O_{11}N_4S_2$ | 92 | 24,3 | 24,2 | 5,2 | 4,5 |
| 2 | $D_5$-Cl | $CF_3(CF_2)_7CH_2COCl$ | $C_{43}F_{17}H_{19}O_{11}N_4S_2$ | 90 | 28,0 | 29,9 | 4,9 | 3,7 |
| 3 | $D_4$-Cl | " | " | 98 | 24,3 | 25,2 | 5,2 | 4,8 |
| 4 | $D_5$-Cl | $CF_3(CF_2)_{6,5}CH_2CH_2OOC-CH{=}CH-COCl$ | $C_{46,5}F_{16}H_{23}O_{13}N_4S_2$ | 87 | 25,1 | 28,7 | 4,6 | 3,7 |
| 5 | $D_5$-Cl | $CF_3(CF_2)_6COCl$ | $C_{41}F_{15}H_{17}O_{11}N_4S_2$ | 60 | 26,1 | 29,5 | 5,1 | 4,2 |
| 6 | $D_5$-Cl | $C_8F_{17}$-m-Phenylen-$SO_2Cl$ | $C_{47}H_{21}F_{17}O_{12}N_4S_3$ | 93 | 25,8 | 26,9 | 4,5 | 4,2 |

$D_5$ = 1,2-Naphthochinon-2-diazid-5-sulfonyl
$D_4$ = 1,2-Naphthochinon-2-diazid-4-sulfonyl

B) Umsetzung von 1,3-Dihydroxy-4-perfluoroctyl-benzol mit 1,2-Naphthochinon-2-diazidsulfonsäurechlorid

25,3 g des Reaktionsprodukts aus A und 26,8 g 1,2-Naphthochinon-2-diazid-5-sulfonsäurechlorid werden in etwa 200 ml Aceton gelöst, und zu der Lösung werden 11 g Triethylamin, gelöst in 50 ml Aceton, innerhalb von 30 Minuten zugetropft, wobei die Reaktionstemperatur durch Eiskühlung unterhalb 30 °C gehalten wird. Nach weiterem 3-stündigem Rühren bei Raumtemperatur wird vom ausgefallenen Triethylaminhydrochlorid abfiltriert und die Lösung in 3-4 Liter angesäuertes Eiswasser eingetropft, wobei sich ein feiner Niederschlag bildet. Nach Stehen über Nacht wird abdekantiert und der Bodensatz zentrifugiert, mit Wasser gewaschen und im Umlufttrockenschrank bei 30 °C getrocknet.

Ausbeute : 30,3 g = 62,5 % d. Th.

| | | | |
|---|---|---|---|
| Summenformel : $C_{34}F_{15}H_{13}O_9N_4S_2$ | % F : | ber. : | 29,4 |
| | | gef. : | 28,6 |
| | % N : | ber. : | 5,8 |
| | | gef. : | 5,6 |

Synthesebeispiel 8

A) Herstellung von Gallussäureperfluoroctylethylester

2,8 g Gallussäure (0,0165 mol), 14 g Perfluoroctylethanol (0,03 mol) und 2 g des sauren Ionenaustauschers Amberlyst(R) 15 werden 6 Stunden auf 110-130 °C erhitzt. Nach Abdestillieren des überschüssigen Alkohols im Vakuum wird der Kolbeninhalt in 30 g Diisopropylether und 5 g Ethylacetat gelöst. Nach Abfiltrieren des Ionenaustauschers wird durch Zugabe von Benzin das Reaktionsprodukt langsam ausgefällt.

Ausbeute : 6 g ockerfarbenes Pulver = 59 % d. Th.

Schmp. : 170-172 °C

Die $^1H$- und $^{19}F$-NMR-Spektren stimmen mit der angenommenen Struktur überein.

B) Umsetzung des Gallussäureperfluoroctylethylesters mit 1,2-Naphthochinon-2-diazidsulfonsäurechlorid

5 g des unter A erhaltenen Gallussäureesters werden auf die gleiche Weise wie in Synthesebeispiel 7B mit 8,75 g Naphthochinondiazidsulfonsäurechlorid durch Zutropfen von 4 g Triethylamin in 100 ml Dioxan umgesetzt.

| | | | |
|---|---|---|---|
| Ausbeute : 10,5 g = 99 % d. Th. | % F : | ber. : | 24,6 |
| | | gef. : | 23,3 |
| | % N : | ber. : | 6,4 |
| | | gef. : | 6,4 |

Anwendungsbeispiele 1 bis 12

Auf elektrochemisch aufgerauhte Aluminiumplatten werden Beschichtungslösungen aufgebracht, mit Warmluft angetrocknet und 1 Minute im Trockenschrank bei 100 °C nachgetrocknet. Die Platten werden mit einer Metallhalogenidlampe (5 kW) im Abstand von 100 cm zwischen Lampe und Vakuumkopierrahmen 100 Sekunden durch eine Negativvorlage eines Stufenkeils belichtet und anschließend mit einer Lösung von

7 g Natriummetasilikat × 9 $H_2O$,
0,05 g des Natriumsalzes eines Fettalkoholpolyglykolether-schwefelsäureesters und
0,01 g eines handelsüblichen Antischaummittels in
92,9 g Wasser

entwickelt. Nach Waschen mit Wasser und kurzem Trocknen bei 100 °C werden die Platten mit einer handelsüblichen Druckfarbe für wasserlosen Offsetdruck mittels einer Rolle eingefärbt.

In der folgenden Tabelle II ist der Gehalt der Beschichtungslösungen an Bindemittel und an Naphthochinondiazidverbindung aus einem der Synthesebeispiele 1 bis 8 in Gewichtsteilen angegeben. Jede Beschichtungslösung enthält ferner 0,02 Gewichtsteile 4-Phenylazo-diphenylamin zur Anfärbung der Schicht sowie 19 Gewichsteile Butanon und 5 Gewichtsteile 1-Methoxy-propan-2-ol als Lösemittel.

Als Ergebnisse der Auswertung sind angegeben die Schichtqualität der trockenen lichtempfindlichen Schicht vor dem Belichten und die Anzahl der Halbtonkeilstufen nach dem Entwickeln und Einfärben. Es wird ein Halbtonstufenkeil mit 13 Dichtestufen verwendet, die sich um jeweils 0,15 unterscheiden, und es ist jeweils die Zahl der ersten freien und der letzten gedeckten Stufe angegeben.

Es ist ferner die visuelle Beurteilung der Farbabstoßung in den Nichtbildstellen (Schicht) und der Farbannahme in den Bildstellen (Träger) angegeben. Diese Eigenschaften sowie die Entwickelbarkeit der

Schichten werden außerdem durch Betrachten der Felder der Rasterstufenkeile beurteilt. Die Rasterstufenkeile haben 12 Felder mit Flächendeckungen von 5 % (Feld 12) bis 95 % (Feld 1) ; es ist jeweils die Nummer des Felds angegeben, bis zu dem die Nichtbildstellen Farbe abstoßen, sowie die Nummer des Felds, von dem an die Bildstellen Farbe annehmen. Die Angaben werden für das 60er Raster (60 Linien/cm) und das 120er Raster (120 Linien/cm) gemacht. Eine optimale Entwicklung und Differenzierung zwischen farbabweisenden Schicht- und farbannehmenden Hintergrundbereichen ist erreicht, wenn das Feld 1 (5 %-Rasterpunkte) schon gute Farbannahme zeigt und das Feld 12 (95 % Rasterpunkte) an den Nichtbildstellen noch genügend farbabstoßend ist, um eine ganzflächige Einfärbung zu verhindern.

Tabelle II

| Anwendungs-beispiel | 1 | 2 | 3 | 4 | 5 | 6 | 7 | 8 | 9 | 10 | 11 | 12 |
|---|---|---|---|---|---|---|---|---|---|---|---|---|
| Bindemittel *) | Menge in Gewichtsteilen | | | | | | | | | | | |
| B1 | | | | | | | | | | | | 0,5 |
| B2 | 0,5 | 0,5 | 0,5 | 0,5 | 0,5 | 0,5 | 0,5 | 0,5 | | | | |
| B3 | | | | | | | | | 0,8 | 0,8 | | |
| B4 | 0,5 | 0,5 | 0,5 | 0,5 | 0,5 | 0,5 | 0,5 | 0,5 | | | | 0,5 |
| B5 | | | | | | | | | | | 1,0 | |
| Vernetzer **) | | | | | | | | | | | | 0,5 |
| Verbindung von Synthesebeispiel | Menge in Gewichtsteilen | | | | | | | | | | | |
| 1 | 1,0 | | | | | | | | 1,2 | | | |
| 2 | | 1,0 | | | | | | | | | | |
| 3 | | | 1,0 | | | | | | | | | |
| 4 | | | | 1,0 | | | | | | 1,4 | | 1,0 |
| 5 | | | | | 1,0 | | | | | | | |
| 6 | | | | | | 1,0 | | | | | | |
| 7 | | | | | | | 1,0 | | | | 1,0 | |
| 8 | | | | | | | | 1,0 | | | | |
| Schicht-qualität. | s g | s g | s g | g | g | m | s g | s g | m | m | schl | g |
| Entwicklungs-zeit (s) | 60 | 60 | 60 | 60 | 30 | 60 | 60 | 60 | 600 | 150 | 120 | 60 |
| Halbtonkeil frei ab/ gedeckt bis | 9/7 | 8/6 | 8/6 | 8/6 | -/13 | 8/6 | 8/6 | 10/6 | 9/6 | 5/5 | 8/3 | 8/7 |
| Farbabstoßung | g | g | g | g | schl | m | g | m | g | g | g | g |
| Farbannahme | g | g | g | g | g | g | g | g | g | g | m | g |
| Rasterkeil Nichtbildstellen abstoßend bis 60er Raster | 1 | 1 | 2 | 1 | 4 | 2 | 1 | 2 | 1 | 1 | 1 | 1 |
| 120er Raster | 3 | 2 | 3 | 2 | 5 | 3 | 2 | 3 | 3 | 2 | 5 | 2 |
| Bildstellen, Farbannahme ab 60er Raster | 12 | 12 | 12 | 12 | 12 | 12 | 12 | 12 | 12 | 12 | 12 | 12 |
| 120er Raster | 12 | 12 | 12 | 12 | 12 | 11 | 12 | 12 | 11 | 12 | 12 | 12 |

Bindemittel *) : Die verwendeten Bindemittel B1 bis B5 werden im Folgenden erläutert
Vernetzer **) : Hexamethoxymethylmelamin
s. g. = sehr gut ; g = gut ; schl = schlecht ; m = mäßig

Herstellung von B1

36 Gewichtsteile eines Polyvinylphenols mit dem mittleren Molekulargewicht 4 500 werden mit 30 Gewichtsteilen Maleinsäuremonochlorid-monoperfluoralkylethylester in Aceton in Gegenwart der äquivalenten Menge Triethylamin umgesetzt. Die Perfluoralkylgruppe hat die Summenformel $C_{7,5}F_{16}$.
Schmelzbereich : 180-200 °C.

Herstellung von B2

Es wird wie bei B1 gearbeitet, nur wird das Polyvinylphenol durch die gleiche Menge eines Polyvinylphenols mit dem mittleren Molekulargewicht 10 000 ersetzt.
Schmelzbereich : 170-190 °C.

Herstellung von B3

24,6 Gewichtsteile eines Kresol-Formaldehyd-Novolaks mit dem Schmelzbereich 105-120 °C nach DIN 53181 werden in Aceton und in Gegenwart der äquivalenten Menge Triethylamin mit 33,2 Gewichtsteilen des bei B1 angegebenen Maleinsäurederivats umgesetzt.
Schmelzbereich : 100-120 °C.

Herstellung von B4

Es wird wie bei B3 gearbeitet, jedoch werden 16,6 Gewichtsteile des Maleinsäurederivats eingesetzt.
Schmelzbereich : 130-150 °C.

Herstellung von B5

60 Gewichtsteile des Mischesters aus Ethylenglykol, Acrylsäure und o-Hydroxybenzoesäure werden mit 40 Gewichtsteilen $C_7F_{15}CH_2CH_2OCO{-}CH{=}CH_2$ copolymerisiert.

Anwendungsbeispiel 13

Eine Druckplatte der im Anwendungsbeispiel 12 angegebenen Zusammensetzung wird wie dort belichtet, dann ohne zu entwickeln 4 Minuten auf 120 °C erwärmt und danach nochmals 100 Sekunden ohne Vorlage belichtet. Beim Entwickeln mit dem in den Anwendungsbeispielen 1 bis 12 angegebenen Entwickler lösen sich innerhalb von 3 Minuten die nicht bildmäßig belichteten Schichtbereiche ab, so daß beim Einfärben mit Druckfarbe ein Positivbild der Vorlage erhalten wird.

Der Halbtonkeil ist bis Stufe 6 frei und ab Stufe 7 gedeckt.

Im 60er Rasterkeil sind die Nichtbildstellen im Feld 12 noch abstoßend und die Bildstellen im Feld 1 bereits farbannehmend.

Im 120er Rasterkeil stoßen die Nichtbildstellen ebenfalls im Feld 12 noch ab und nehmen die Bildstellen im Feld 2 bereits Farbe an.

**Patentansprüche**

1. Perfluoralkylgruppen aufweisende 1,2-Naphthochinon-2-diazidsulfonsäureester der allgemeinen Formel I

$$(R_FW)_p{-}\underset{}{\overset{\displaystyle R^1 \atop |}{Ar}}({-}OD)_n \qquad (I)$$

worin

Ar einen ein- bis dreikernigen aromatischen Rest,
D einen 1,2-Naphthochinon-2-diazid-4- oder einen 1,2-Naphthochinon-2-diazid-5-sulfonylrest,
$R_F$ einen Perfluoralkylrest mit 5 bis 15 Kohlenstoffatomen,
W eine Einfachbindung oder eine der Gruppen

$-(CH_2)_mCOO-$
$-(CH_2)_mO-C_0H_{20}-COO-$
$-(CH_2)_mOOC-C_0H_{20}-COO-$
$-(CH_2)_mOOC-CH{=}CH-COO-$
$-(CH_2)_mCO-$
$-(CH_2)_mOOC-CHR^2-O-$
$-(CH_2)_mOOC-$
$-(CH_2)_mSO_2NH-$
$-C_6H_4SO_2NH-$
$-(CH_2)_mCONH-$

$-(CH_2)_mSO_3-$
$-C_6H_4SO_3-$
$-(CH_2)_mOOC-C_0H_{20}-CONH-$
$-(CH_2)_mOOC-CH{=}CH-CONH-$,

$R^1$ ein Wasserstoff- oder Halogenatom, eine Alkyl- oder Alkoxygruppe mit 1 bis 5 Kohlenstoffatomen, eine Acetyl- oder Propionylgruppe,
$R^2$ eine Alkylgruppe mit 1 bis 12 Kohlenstoffatomen,
m 0 oder eine Zahl von 1 bis 6,
n eine Zahl von 1 bis 3,
o eine Zahl von 1 bis 12 und
p eine Zahl von 1 bis 3
bedeutet.

2. Naphthochinondiazidsulfonsäureester nach Anspruch 1, dadurch gekennzeichnet, daß Ar ein Benzophenonrest ist.

3. Lichtempfindliches Reproduktionsmaterial für die Herstellung von wasserlos druckenden Flachdruckformen, bestehend aus einem Schichtträger und einer lichtempfindlichen Schicht, die ein 1,2-Naphthochinondiazid enthält, dadurch gekennzeichnet, daß das 1,2-Naphthochinondiazid eine Verbindung der allgemeinen Formel I

$$\underset{}{(R_FW)_p-\overset{\overset{\displaystyle R^1}{|}}{Ar}(-OD)_n} \qquad (I)$$

ist, worin
Ar einen ein- bis dreikernigen aromatischen Rest,
D einen 1,2-Naphthochinon-2-diazid-4- oder einen 1,2-Naphthochinon-2-diazid-5-sulfonylrest,
$R_F$ einen Perfluoralkylrest mit 5 bis 15 Kohlenstoffatomen,
W eine Einfachbindung oder eine der Gruppen

$-(CH_2)_mCOO-$
$-(CH_2)_mO-C_0H_{20}-COO-$
$-(CH_2)_mOOC-C_0H_{20}-COO-$
$-(CH_2)_mOOC-CH{=}CH-COO-$
$-(CH_2)_mCO-$
$-(CH_2)_mSO_3-$
$-C_6H_4SO_3-$
$-(CH_2)_mOOC-CHR^2-O-$
$-(CH_2)_mOOC-$
$-(CH_2)_mSO_2NH-$
$-C_6H_4SO_2NH-$
$-(CH_2)_mCONH-$
$-(CH_2)_mOOC-C_0H_{20}-CONH-$
$-(CH_2)_mOOC-CH{=}CH-CONH-$,

$R^1$ ein Wasserstoff- oder Halogenatom, eine Alkyl- oder Alkoxygruppe mit 1 bis 5 Kohlenstoffatomen, eine Acetyl- oder Propionylgruppe,
$R^2$ eine Alkylgruppe mit 1 bis 12 Kohlenstoffatomen,
m 0 oder eine Zahl von 1 bis 6,
n eine Zahl von 1 bis 3,
o eine Zahl von 1 bis 12 und
p eine Zahl von 1 bis 3
bedeutet.

4. Lichtempfindliches Reproduktionsmaterial nach Anspruch 3, dadurch gekennzeichnet, daß es ferner ein wasserunlösliches, in wäßrig-alkalischen Lösungen lösliches polymeres Bindemittel enthält.

5. Lichtempfindliches Reproduktionsmaterial nach Anspruch 4, dadurch gekennzeichnet, daß das Bindemittel Einheiten mit jeweils mindestens einem Perfluoralkylrest mit 5 bis 15 Kohlenstoffatomen enthält.

**Claims**

1. Perfluoroalkyl-group-containing 1,2-naphthoquinone-2-diazide sulfonic acid esters corresponding to the general formula I

$$(R_FW)_p-\overset{\overset{\displaystyle R^1}{|}}{Ar}(-OD)_n \qquad (I)$$

in which
Ar denotes a mononuclear to trinuclear aromatic radical

D is a 1,2-naphthoquinone-2-diazide-4-sulfonyl radical or a 1,2-naphthoquinone-2-diazide-5-sulfonyl radical,

$R_F$ is a perfluoroalkyl radical having from 5 to 15 carbon atoms,

W is a single bond or one of the groups

$—(CH_2)_mCOO—$
$—(CH_2)_mO—C_oH_{2o}—COO—$
$—(CH_2)_mOOC—C_oH_{2o}—COO—$
$—(CH_2)_mOOC—CH{=}CH—COO—$
$—(CH_2)_mCO—$
$—(CH_2)_mSO_3—$
$—C_6H_4SO_3—$
$—(CH_2)_mOOC—CHR^2—O—$
$—(CH_2)_mOOC—$
$—(CH_2)_mSO_2NH—$
$—C_6H_4SO_2NH—$
$—(CH_2)_mCONH—$
$—(CH_2)_mOOC—C_oH_{2o}—CONH—$
$—(CH_2)_mOOC—CH{=}CH—CONH—$,

$R^1$ is a hydrogen or halogen atom, an alkyl or alkoxy group having from 1 to 5 carbon atoms, an acetyl or propionyl group,

$R^2$ is an alkyl group having from 1 to 12 carbon atoms,

m is 0 or a number from 1 to 6,

n is a number from 1 to 3,

o is a number from 1 to 12, and

p is a number from 1 to 3.

2. A naphthoquinone diazide sulfonic acid ester as claimed in claim 1, wherein Ar is a benzophenone radical.

3. Light-sensitive reproduction material for use in the production of planographic printing plates for waterless printing, which comprises a support and a light-sensitive layer containing a 1,2-naphthoquinone diazide, wherein the 1,2-naphthoquinone diazide is a compound corresponding to the general formula I

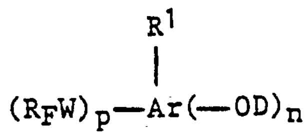

(I)

in which

Ar denotes a mononuclear to trinuclear aromatic radical,

D is a 1,2-naphthoquinone-2-diazide-4-sulfonyl radical or a 1,2-naphthoquinone-2-diazide-5-sulfonyl radical,

$R_F$ is a perfluoroalkyl radical having from 5 to 15 carbon atoms,

W is a single bond or one of the groups

$—(CH_2)_mCOO—$
$—(CH_2)_mO—C_oH_{2o}—COO—$
$—(CH_2)_mOOC—C_oH_{2o}—COO—$
$—(CH_2)_mOOC—CH{=}CH—COO—$
$—(CH_2)_mCO—$
$—(CH_2)_mSO_3—$
$—C_6H_4SO_3—$
$—(CH_2)_mOOC—CHR^2—O—$
$—(CH_2)_mOOC—$
$—(CH_2)_mSO_2NH—$
$—C_6H_4SO_2NH—$
$—(CH_2)_mCONH—$
$—(CH_2)_mOOC—C_oH_{2o}—CONH—$
$—(CH_2)_mOOC—CH{=}CH—CONH—$,

$R^1$ is a hydrogen or halogen atom, an alkyl or alkoxy group having from 1 to 5 carbon atoms, an acetyl or propionyl group,

$R^2$ is an alkyl group having from 1 to 12 carbon atoms,

m is 0 or a number from 1 to 6,

n is a number from 1 to 3,

o is a number from 1 to 12, and

p is a number from 1 to 3.

4. A light-sensitive reproduction material as claimed in claim 3, which additionally contains a polymeric binder which is insoluble in water and soluble in aqueous-alkaline solutions.

5. A light-sensitive reproduction material as claimed in claim 4, wherein the binder comprises units which contain, in each case, at least one perfluoroalkyl radical having from 5 to 15 carbon atoms.

## Revendications

1. Esters d'acides 1,2-naphtoquinone-2-diazidesulfoniques comportant des groupes perfluoroalkyle, de formule générale I

$$(R_FW)_p\text{—}\underset{}{\overset{R^1\atop |}{Ar}}(\text{—}OD)_n \qquad (I)$$

dans laquelle

Ar représente un radical aromatique à 1-3 noyaux,

D représente un radical 1,2-naphtoquinone-2-diazide-4-sulfonyle ou un radical 1,2-naphtoquinone-2-diazide-5-sulfonyle,

$R_F$ représente un radical perfluoro-alkyle ayant de 5 à 15 atomes de carbone,

W représente une liaison simple ou l'un des groupes

$—(CH_2)_mCOO—$
$—(CH_2)_mO—C_oH_{2o}—COO—$
$—(CH_2)_mOOC—C_oH_{2o}—COO—$
$—(CH_2)_mOOC—CH{=}CH—COO—$
$—(CH_2)_mCO—$
$—(CH_2)_mSO_3—$
$—C_6H_4SO_3—$
$—(CH_2)_mOOC—CHR^2—O—$
$—(CH_2)_mOOC—$
$—(CH_2)_mSO_2NH—$
$—C_6H_4SO_2NH—$
$—(CH_2)_mCONH—$
$—(CH_2)_mOOC—C_oH_{2o}—CONH—$
$—(CH_2)_mOOC—CH{=}CH—CONH—$,

$R^1$ représente un atome d'hydrogène ou d'halogène, un groupe alkyle ou alcoxy ayant de 1 à 5 atomes de carbone, un groupe acétyle ou propionyle ;

$R^2$ représente un groupe alkyle ayant de 1 à 12 atomes de carbone,

m est zéro ou un nombre allant de 1 à 6,

n est un nombre allant de 1 à 3,

o est un nombre allant de 1 à 12 et

p est un nombre allant de 1 à 3.

2. Esters d'acides naphtoquinonediazidesulfoniques selon la revendication 1, caractérisés en ce que Ar est un radical benzophénone.

3. Matériau de reproduction photosensible pour la production de formes d'impression à plat imprimant à sec, composé d'un support de couche et d'une couche photosensible qui contient un 1,2-naphtoquinonediazide, caractérisé en ce que le 1,2-naphtoquinonediazide est un composé de formule générale I

$$(R_FW)_p\text{—}\underset{}{\overset{R^1\atop |}{Ar}}(\text{—}OD)_n \qquad (I)$$

dans laquelle

Ar représente un radical aromatique à 1-3 noyaux,

D représente un radical 1,2-naphtoquinone-2-diazide-4-sulfonyle ou un radical 1,2-naphtoquinone-2-diazide-5-sulfonyle,

$R_F$ représente un radical perfluoro-alkyle ayant de 5 à 15 atomes de carbone,

W représente une liaison simple ou l'un des groupes

$—(CH_2)_mCOO—$
$—(CH_2)_mO—C_oH_{2o}—COO—$
$—(CH_2)_mOOC—C_oH_{2o}—COO—$
$—(CH_2)_mOOC—CH{=}CH—COO—$
$—(CH_2)_mCO—$
$—(CH_2)_mSO_3—$
$—C_6H_4SO_3—$
$—(CH_2)_mOOC—CHR^2—O—$
$—(CH_2)_mOOC—$
$—(CH_2)_mSO_2NH—$
$—C_6H_4SO_2NH—$
$—(CH_2)_mCONH—$
$—(CH_2)_mOOC—C_oH_{2o}—CONH—$
$—(CH_2)_mOOC—CH{=}CH—CONH—$,

$R^1$ représente un atome d'hydrogène ou d'halogène, un groupe alkyle ou alcoxy ayant de 1 à 5 atomes de carbone, un groupe acétyle ou propionyle ;

$R^2$ représente un groupe alkyle ayant de 1 à 12 atomes de carbone,

m est zéro ou un nombre allant de 1 à 6,

n est un nombre allant de 1 à 3,

o est un nombre allant de 1 à 12 et

p est un nombre allant de 1 à 3.

4. Matériau de reproduction photosensible selon la revendication 3, caractérisé en ce qu'il contient en outre un liant polymère insoluble dans l'eau, soluble dans des solutions aqueuses alcalines.

5. Matériau de reproduction photosensible selon la revendication 4, caractérisé en ce que le liant contient des motifs comportant chacun au moins un reste perfluoro-alkyle ayant de 5 à 15 atomes de carbone.